# EUROPEAN PATENT SPECIFICATION

(11) **EP 3 252 948 B1**
(45) Date of publication and mention of the grant of the patent: **06.05.2020**
(21) Application number: 17174392.5
(22) Date of filing: 02.06.2017
(51) Int. Cl.: H03F 1/02, H03F 3/189, H03F 3/72, H03G 1/00

(54) **AMPLIFICATION SYSTEM FOR TELECOMMUNICATION SIGNALS**
VERSTÄRKERANORDNUNG FÜR TELEKOMMUNIKATIONSSIGNALE.
SYSTÈME D'AMPLIFICATION POUR DES SIGNAUX DE TÉLÉCOMMUNICATION.

(30) Priority: 03.06.2016 ES 201600474
(43) Date of publication of application: 06.12.2017
(73) Proprietor: Televés, S.A., 15706 Santiago de Compostela (ES)
(72) Inventor: Peláez Pérez, Ana María, 15706 Santiago de Compostela (ES); Ricart Fernández, Jesús, 15706 Santiago de Compostela (ES); López Arca, Gumersindo, 15706 Santiago de Compostela (ES)

(56) References cited:
- EP-A1- 2 485 393
- WO-A1-2011/052855
- US-A1- 2005 083 117
- US-A1- 2005 186 919
- US-A1- 2016 056 774

## Description

### FIELD OF THE INVENTION

The present invention relates to a system for the amplification of telecommunication signals, in particular for the amplification of radio, television and/or data signals according to claim 1.

### BACKGROUND OF THE INVENTION

A low noise amplifier (also called LNA, *"Low Noise Amplifier*") is a critical element in any communications reception system, as it is the first active element of the system after the antenna. Therefore, in order to increase the sensitivity of the receiver and reduce the contribution of the LNA to total system noise, it is necessary to have a low noise figure and a high gain. However, in environments where the input signal to the receiver is high leveled it is not necessary to have such a high gain, and higher noise levels are admissible. It is even desirable to have no gain in order not to cause saturation effects on the rest of the system elements, which may degrade the signal as a result of the intermodulation originated in the active device.

In the latter case it is desirable for the LNA to have a switching system which permits the switching of the input signal to the output without being amplified. This element is called a bypass circuit.

Numerous configurations of LNA with Bypass are known. However, one of the main disadvantages presented is the fact that the Bypass circuit consumes power when it is activated, as occurs in the circuit described in document US 6,977,552. Another disadvantage is that, like in the circuit described in document US 6,930,546, although the bypass circuit does not consume power, it still needs a polarization / control voltage to be activated. This is a disadvantage since it implies that in Bypass mode, which is a passive mode, an additional external element is needed to control the device.

Although solutions have been proposed to overcome the above disadvantages as described in EP 1199771, in which the main drawback lies in the limited gain that can be obtained at the output of the amplifier. This is due to the fact that the maximum gain of the LNA is limited by the isolation between the input and the output of the amplifier that is possible to obtain from the Bypass circuit, which means that the majority of LNA embodiments with a Bypass circuit are limited to single stage or moderate gain amplifiers.

US2005/0186919 describes in Fig 6. a transmitter where an amplification of the input signal (RFin) is done though transistor 21 polarized by the network 24, and therefore power consumption is required in any case.

WO2001052855 includes a LNA circuit with λ/4 transformer lines. This solution is only valid for a limited bandwidth, and therefore it is not valid for reception of wideband signals.

EP 2 485 393 discloses that the voltage amplifier module 11 comprises a fixed gain part 13 with a fixed gain Go and a commutable gain. A first switch 15 is disposed in parallel with the commutable gain part 14, that is to say between the input of the commutable gain part 14 and the output of the commutable gain part 14.

US 2016/0056774 describes an LNA where the operation mode of LNA module 100 may be selected by providing a digital control signal via control bus CTL to switch logic 101 that controls the state of switches 110,112,114,116,118 and 122, as well as the state of adjustable capacitor 130.

US 2005/0083117 describes a power based on Impedance matching with passive components, but always a polarization voltage is required for the system to be configured in any mode.

### DESCRIPTION OF THE INVENTION

The aim of this invention is a system for the amplification of telecommunication signals, in particular for the amplification of radio, television and/or data signals, with an input and an output, having two modes of operation: a first mode in which said signal, after being amplified, passes to the output and a second mode allowing the passage of a signal present at the input to the output without being amplified.

This purpose is achieved by a system as described in the claims.

This system for the amplification of telecommunication signals, in particular for the amplification of radio, television and/or data signals has a range of advantages.

The system for the amplification of telecommunication signals in particular for the amplification of radio, television and/or data signals comprises an input, an output, an amplification module configured in such a way that it has two modes of operation, a first mode called an amplification mode and a second mode called a cut-off mode; a switching module having two modes of operation, a first mode called signal passing mode and a second mode called isolation mode; a bypass module having two modes of operation, a first mode called signal passing mode and a second mode called isolation mode and a polarization network which generates different control voltage values from an input voltage.

The telecommunication signal amplification system has two modes of operation that are selectable depending on one of the control voltage values. In the first mode of operation, called amplification mode, the control voltage value(s) are such that the amplification module is in amplification mode, the switching module is in signal passing mode and the bypass module 3 is in isolation mode, and the signals present at the input of the amplification system are amplified through the amplification module and placed at the output of the amplification system. In the second mode of operation, called signal passing mode, the control voltage value(s) are such that the bypass module is in signal passing mode, the switching module is in isolation mode and the signals at the input of the amplification system are not amplified and are outputted from the amplification system through the bypass module.

This two modes of operation are independent of each other, amplification and passing, selectable by means of control voltages without having to act physically on the system (e.g. with a switch). This arrangement of the different modules makes it possible to obtain high values of gain in the amplification mode, thanks to the rejection obtained by the bypass module that prevents oscillation effects, by feedback of the output towards the input; at the same time it allows for very low attenuation values in the signal passing mode by having a switching module which, in the passing mode, provides a connection between the output of the amplifier module and the output of the system and, in the isolation mode, isolates the output of the amplifier module from the system output.

In another example according to the invention, the amplification system is in signal passing mode when any of the control voltage value(s) is zero volts.

This example has the advantage of requiring a smaller number of control voltages in the second mode of operation, thereby improving its energy efficiency.

, The amplification system is in signal passing mode when the or all control voltage value(s) is (are) zero volts.

This has the advantage that in the second mode of operation, the energy consumption is zero and the control voltages are equal to zero volts, making it a passive system that does not need an external power supply and additionally does not need to vary the polarization network.

At least one of the modules comprising the amplification system, i.e. the amplification module and/or the switching module and/or the bypass module, are constituted by amplification blocks, switching blocks and bypass blocks respectively.

This has the advantage of increasing the flexibility of the design of the various amplifier, switching and bypass modules, in order to comply with different global requirements of the amplifier system (such as gain, isolation between input and output or output impedance), just by varying the number of amplification and/or switching and/or bypass blocks.

The amplification blocks have two modes of operation, a first mode of operation called amplification mode in which the signal is amplified at the input of the block and a second mode of operation called cut-off mode in which the signal at the input of the block is not allowed to pass to its output.

This has the advantage that it allows for the possibility of adapting the response of each of the amplification blocks (and consequently of the amplification module) to the different modes of operation of the amplifier system, improving the overall performance of the system.

The switching blocks are of a first type called a serial switching block or of a second type called a parallel switching block, both with a first mode of operation called passing mode and a second mode of operation called cut-off mode.

This example has the advantage that having two types of parallel and serial block allows greater flexibility in the design to adjust the electrical properties (insertion and insulation losses, respectively) of the switching module to the requirements to be established.

In a preferable embodiment ccording to the invention, at least the last switching block of the switching module is a serial switching block.

This example has the advantage of increasing the isolation between the output of the bypass module and the output of the switching module when it is in isolation mode, improving the performance of the amplification system in its passing mode.

In a preferable embodiment according to the invention, the bypass blocks are of a first type called a serial bypass block or of a second type called a parallel bypass block, both with a first mode of operation called a passing mode and a second mode of operation called cut-off mode.

This embodiment has the advantage that in the signal passing mode of the amplification system a connection is provided between the input and the output of the amplifier system whereas in the isolation mode the input of the amplifier system is isolated from the output of the amplifier system so that any signal present at the input of the amplifier system is channelled towards the input of the amplifier module without loss of performance.

In addition, having two types of block (serial and parallel) has the advantage that it allows greater flexibility in the design to adjust the electrical properties (insertion loss and isolation, respectively) of the bypass module to the requirements to be established.

In a prefereable embodiment according to the invention, the bypass module contains at least three bypass blocks. Of these, at least the first and last bypass blocks are serial, and at least one other block between them is parallel.

This embodiment has the advantage of having a bypass module which in signal passing mode provides a connection with low insertion loss between the input and the output of the amplifier system. In addition, the bypass module in isolation mode provides high isolation between the input and output of the amplifier system which avoids undesired feedback effects when the amplification system is in amplification mode.

In a preferable embodiment according to the invention, each amplification block contains a transistor made in PHEMT (*Pseudomorphic High electron mobility transistor*) technology and one or two capacitors, the operation of which is controlled by three control voltages generated by the polarization network.

This embodiment has the advantage that the mode of operation of each amplification block can be controlled through the polarization of the transistor it contains without requiring additional control voltages, which improves the efficiency of the assembly by using the same voltage for the control and the polarization of the transistors.

In another example according to the invention, each serial switching block contains three resistors and a transistor made in PHEMT ("*Pseudomorphic High electron mobility transistor*") technology, the operation of which is controlled by two control voltages generated by the polarization network. In the case of a parallel bypass block, each block contains a resistor, a PHEMT ("*Pseudomorphic High electron mobility transistor*") transistor, and a capacitor whose operation is controlled by a control voltage generated by the polarization network.

This example has the advantage that the mode of operation of each switching block can be controlled through the polarization of the transistor it contains without requiring additional control voltages, which improves the efficiency of the assembly by using the same voltage for the control and the polarization of the transistors.

In another example according to the invention, the drain and source terminals of the switching block transistor can be exchanged.

This has the advantage of having greater flexibility in the design of the switching block.

In another example according to the invention, each serial bypass block contains two resistors and a transistor made in PHEMT ("*Pseudomorphic High electron mobility transistor*") technology, the operation of which is controlled by two control voltages generated by the polarization network. In the case of a parallel bypass block, each block contains a resistor, a PEMT ("*Pseudomorphic High electron mobility transistor*") transistor, and a capacitor whose operation is controlled by a control voltage generated by the polarization network.

This example has the advantage that the mode of operation of each bypass block can be controlled through the polarization of the transistor it contains without requiring additional control voltages, which improves the efficiency of the assembly by using the same voltage for the control and the polarization of the transistors.

In another example according to the invention, the drain and source terminals of the bypass block transistor can be exchanged.

This has the advantage of having greater flexibility in the design of the bypass block.

In another example according to the invention, the PHEMT transistors may be of the *enhancement* or *depletion* type, so that the transistor type of the serial switching blocks must be of the same type as the parallel bypass blocks, and the transistor type of the parallel switching blocks must be of the same type as the serial bypass blocks.

This example has the advantage that different types of PHEMT technology transistors can be used interchangeably.

In another example according to the invention, the amplification system consists of
- an input adaptation block of the amplification module, consisting of an inductance,
- an amplification module containing exactly two amplification blocks
- an output adaptation block which is a connection line
- a switching module containing exactly one serial switching block,
- a decoupling block of the input of the bypass module which is a decoupling capacitor
- a bypass module containing three bypass blocks, the first and third by serial type and the second by parallel type and
- a decoupling block of the output of the bypass module which is a decoupling capacitor.

This embodiment has the advantage of obtaining a high gain in the amplification mode and a low insertion loss in the signal passing mode. All this with the minimum number of amplification, switching and bypass blocks, in addition to a small number of control voltages.

In order to complement the description of the invention and to help with a better understanding of the features and advantages, a set of drawings is attached as an integral part of said description in which, in an illustrative and non-limiting manner, the following has been represented:
Figure 1.- General block diagram of the amplification system SA according to the invention
Figure 2.- Block diagram of the amplification system SA according to the invention with identification of the blocks constituting each module
Figure 3.- Example of switching module 2 according to the invention
Figure 4.- Example of bypass module 3 according to the invention
Figure 5.- Example of amplification block BAi according to the invention
Figure 6.- Example of a serial type switching block BCjS the according to the invention
Figure 7.- Example of a parallel type switching block BCjP according to the invention
Figure 8.- Example of a serial type bypass block BBkS according to the invention
Figure 9.- Example of a parallel type bypass block BBkP of according to the invention
Figure 10.- Example of embodiment according to the invention
Figure 11.- Response graph of the embodiment of the amplification system according to clause number 24

### PREFERRED EMBODIMENT OF THE INVENTION

In view of the aforementioned figures and according to the numbering system used, an example of a preferred embodiment of the invention can be seen that comprises the parts and elements described and indicated in detail below. The invention is defined by the appended claims.

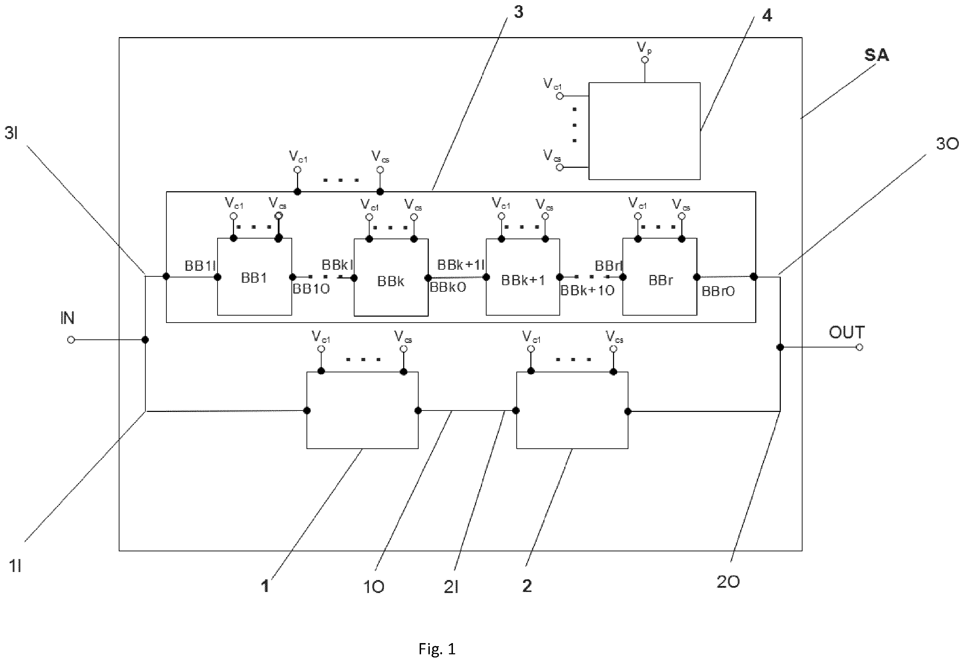

Thus, and as shown in Fig. 1, a possible preferred embodiment of the system for the amplification of SA telecommunication signals, in particular for the amplification of radio, television and/or data signals, essentially comprises the following functional elements and characteristics:
- An input IN
- An output OUT,
- An amplification module 1, with an input 1I and an output 1O, which is configured in such a way as to have two modes of operation, a first mode called an amplification mode and a second mode called a cut-off mode.
- When operating in amplification mode, the amplification module 1 places at the output 1O the signal present at the input 1I, being the signal amplified.
- When operating in cut-off mode, the amplification module 1 isolates the output 1O of the amplification module 1 from the input 1I of amplification module 1.
- A switching module 2 with an input 2I and an output 2O, which is configured in such a way as to have two modes of operation, a first mode called a signal passing mode and a second mode called isolation mode.
- When operating in signal passing mode, the switching module 2 connects the output 2O of the switching module 2 to the input 2I of the switching module 2.
- When operating in isolation mode, the switching module 2 isolates the output 2O of the switching module 2 from the input 2I of switching module 2.
- A bypass module 3 with an input 3I and an output 3O, and having two modes of operation, a first mode called a signal passing mode and a second mode called isolation mode
- When operating in passing mode, bypass module 3 connects the output 30 of the bypass module 3 of the input 3I of bypass module 3
- When operated in isolation mode, bypass module 3 isolates the output 3O of the bypass module 3 from the input 3I of bypass module 3
- A polarization network 4 which generates from an input voltage Vp between one and an integer s of control voltage values Vc1, ..., Vcs. One possible value of these voltages is 0 volts, considering therefore the ground connection as a possible voltage generated by the polarization network 4.

In this preferred embodiment, the telecommunication signal amplification system SA has two modes of operation which are selectable depending on one of the control voltage values Vc1, ..., Vcs generated by the polarization network 4.

In the first mode of operation of this first preferred embodiment, called the amplification mode, the control voltage value(s) Vc1, ..., Vcs are such that the amplification module 1 is in amplification mode, the switching module 2 is in signal passing mode and the bypass module 3 is in isolation mode and the signals present at the input IN of the amplification system SA are amplified through the amplification module 1 and set to the OUT output of the amplification system SA.

In the second mode of operation of this first preferred embodiment, called signal passing mode, the control voltage value(s) Vc1, ..., Vcs are such that the bypass module 3 is in signal passing mode, the switching module 2 is in isolation mode and the signals present at the input IN of the amplification system SA are not amplified and are sent to the output OUT of the amplification system SA through bypass module 3.

According to the invention, the amplification system SA is in signal passing mode when any of the control voltage value(s) Vc1, ..., Vcs is zero volts.

The amplification system SA is in signal passing mode when the or all control voltage value(s) Vc1, ..., Vcs is (are) zero volts.

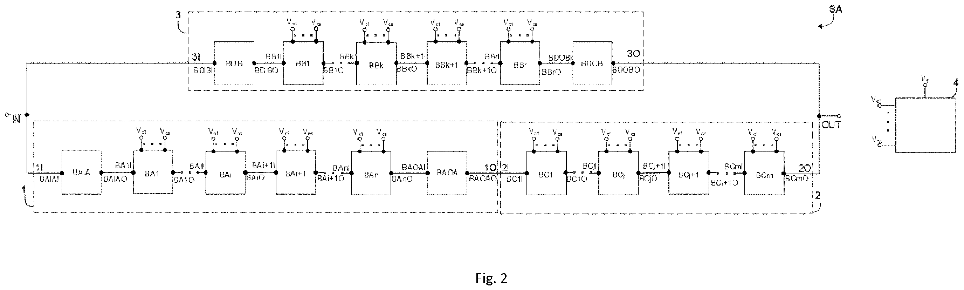

Other possible embodiments are shown in Figure 2. In them, at least one of the modules that make up the amplification system SA, i.e. the amplification module 1 and/or switching module 2 and/or bypass module 3, are constituted by blocks.

An amplification module 1 constituted by blocks according to figure 2 comprises
- an input adaptation block BAIA of the amplification module 1 having a BAIAI input and a BAIAO output. This block corresponds, from merely an inductance to a complex adaptation circuit.
- A BAOA output adaptation block of the amplification module 2 having a BAOAI input and a BAOAO output, the BAOAO output forming the output 1O of the amplification module 1. This block may correspond, for example, from a connection line to a complex adaptation circuit.
- An integer number between 1 and n of amplification blocks BA1, ..., BAn, each of which has an input BA1I, ..., BAnI and an output BA1O, ..., BAnO respectively, and whose operation is controlled by one or more control voltages Vc1, ..., Vcs generated by the polarization network 4.

In this amplification module 1 according to figure 2
- the input BAIAI of the input adaptation block BAIA of the amplification module 1 constitutes the input 1l of the amplification module 1,
- The input BAl1 of the first amplification block BA1 is connected to the output BAIAO of the input adaptation block BAIA of the amplification module 1,
- The output BAiO of the i-th amplification block (BAi) is connected to the input BAi+1l of the amplification block i+1-th BAi+1 for any integer value of i comprised between 1 and n-1,
- The output BAnO of the n-th amplification block BAnO is connected to the input BAOAI of the BAOA output adaptation block of the amplification module 1,
- The BAOAO output of the BAOA output adaptation block of the amplification module 1 constitutes the output 1O of the amplification module 1,

A switching module 2 consisting of blocks according to figure 2 comprises an integer number of between 1 and m switching blocks BC1, ..., BCm, each of which has an input BC1I, ..., BCmI and an output BC1O, ... , BCmO respectively, and whose operation is controlled by one or more control voltages Vc1, ..., Vs generated by the polarization network 4.

In this switching module 2 according to figure 2
- The input BC1I of the first switching block BC1 constitutes the input 2I of the switching module 2,
- The output BCjO of the j-th switching block BCj is connected to the input (BCj + 1l) of the j + 1-th switching block BCj + 1 for any integer value of j comprised between 1 and m-1, and
- The output BCmO of the last switching block BCm constitutes the output 2O of the switching module 2.

A bypass module 3 constituted by blocks according to figure 2 comprises
- an input decoupling block BDIB of the bypass module 3 having a BDIBI input and a BDIBO output. This input decoupling block may simply consist of a capacitor or alternatively of a complex decoupling circuit,
- An integer number of between 1 and r bypass blocks BB1, ..., BBr which have an input BB1I, ..., BBrI and an output BB1O, ..., BBrO respectively and whose operation is controlled by one or more control voltages Vc1, ..., Vs generated by the polarization network 4,
- A output decoupling block BDOB of the bypass module 3 having a BDOBI input and a BDOBO output. This input decoupling block may simply consist of a capacitor or alternatively of a complex decoupling circuit.

In this bypass module 3 according to figure 2
- The input BDIBI of the input decoupling block BDIB of the bypass module 3 constitutes the input 3l of the bypass module 3,
- the input BBl1 of the first bypass block BB1 is connected to the output BDIBO of the input decoupling block BDIB of the bypass module 3.
- The output BBkO of the k-th bypass block BBk is connected to the input BBk+1l of the bypass block k+1-th BBk+1 for any integer value of k between 1 and r-1. Between these blocks, it is necessary to introduce a capacitor in the case where the control voltages are different
- The output BBrO of the last bypass block BBr is connected to the input BDOBI of the bypass block BDOB of bypass module 3, and
- The output BDOBO of the decoupling block output BDOB of bypass module 3 constitutes output 30 of bypass module 3

In another embodiment of the invention according to Figure 2, the i-th amplification block BBi, for any integer i comprised between 1 and n has two modes of operation, a first mode of operation called an amplification mode and a second mode of operation called cut-off mode.
- In the amplification mode, the i-th amplification block BAi Isets at its output (BAiO) the signal present at the input BAil, being the signal amplified, and
- In the cut-off mode, the i-th amplification block BAi locates at its output BAiO the signal present at the input BAil, amplified signal, preventing the passage of the signal present at the input BAil to the output BAiO.

Thus, and in accordance with another embodiment shown in FIG. 2, for the amplification module 1 to be in amplification operation mode, each and every one of the amplification blocks BA1, ..., Ban must be in amplification mode. Alternatively, for the amplification module 1 to be in the cut-off mode, the first amplification block BA1 of the amplification blocks BA1, ..., BAn being in cut-off mode is enough.

In Figure 2, the j-th switching block BCj, for any integer value of j comprised between 1 and m, may be of a first type called a serial switching block BCjS, with an input BCjSI and an output BCjSO, or alternatively of a second type called a parallel switching block BCjP, with a input BCjPI and a output BCjSO.

A serial type switching block BCS with an input BCSI and an output BCSO has two modes of operation: a first mode of operation called a passing mode and a second mode of operation called a cut-off mode.

In a serial type switching block BCS in passing mode, a connection is established between its output BCSO and its input BCSI. Connection in this case means enabling a low impedance path, so that it favours the passing of the direct signal between the input BCSI and the output BCSO with respect to any alternative path.

In a serial switching block BCS in cut-off mode, the output BCSO is isolated from the inputBCSI . Isolating is understood as the fact of preventing the signal present at the input BCSI from passing to the output BCSO.

A BCP parallel type switching block has two modes of operation: a first mode of operation called a passing mode and a second mode of operation called a cut-off mode.

In a parallel type switching block BCP in passing mode, an grounding path for the signal present at the input BCPI is enabled. Enabling an grounding path is understood in this context as establishing a very low impedance connection between the input BCPI and ground, favouring the passg of the signal with respect to any other alternative path.

In a parallel type switching block BCP in cut-off mode, a connection is established between the output BCPO and the input BCPI. Connection in this case means enabling a low impedance path, so that it favours the passage of the direct signal between the input BCSI and the output BCSO with respect to any alternative path.

In figure 2, at least the last switching block BCm of the switching module 3, the last switching block being understood as the one whose BCmO output constitutes the output 30 of the switching module 3 is connected, is a serial type switching block BCS.

According to FIG. 2, for the switching module 2 to be in signal passing mode, all the serial switching blocks BC1S, ..., BCmS must be in passing mode, and all the BC1P, ..., BCm-1P parallel type switching blocks must be in cut-off mode. In another case, for the switching module 2 to be in isolation mode, at least one serial switching block BC1S, ..., BCmS which is closest to the output of the switching module 20 than the parallel type switching block BC1P, ..., BCm-1P closest to the output of the switching module (20) and in passing mode, is in cut-off mode.

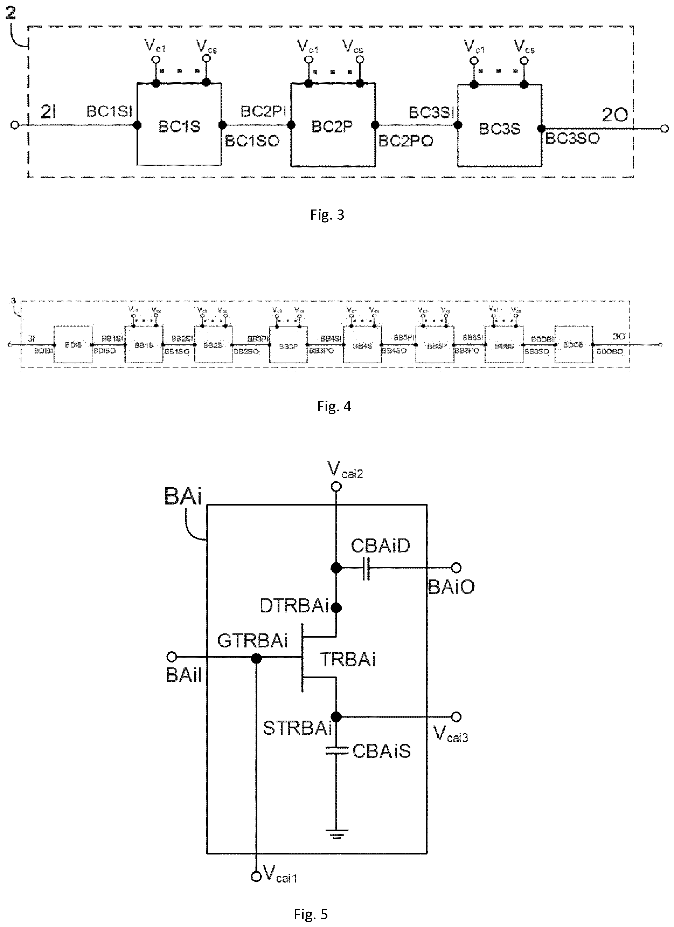

This is illustrated by an example shown in Figure 3, in which a switching module 2 as described above is shown formed by three switching blocks, two serial blocks BC1S and BC3S, and one of parallel type BC2S.

For the switching module 2 to being in signal passing mode, it is strictly necessary for the serial switching blocks BC1S and BC3S to be in passing mode and for the parallel switching blocks BC2P to be in cut-off mode.

On the other hand, the switching module 2 is in isolation mode in the following cases:
1. If the parallel switching block BC2P is in passing mode and the serial switching block BC3S is in cut-off mode.
2. If the parallel switching block BC2P is in cut-off mode and at least one of the serial switching blocks BC1S, BC3 is in cut-off mode.

In Figure 2, the k-th bypass block BBk, for any integer value of k between 1 and r, is of a first type called a serial switching block BBkS, with a BBkSI input and A BBkSO output, or a second type called a BBkP parallel switching block, with a BBkPI input and a BBkSO output

A serial type bypass block BBS with a BBSI input and a BBSO output has two modes of operation: a first mode of operation called a passing mode and a second mode of operation called a cut-off mode.

In a serial type bypass block BBS in passing mode, a connection is established between its output BBSO and its input BBSI. Connection in this case means enabling a low impedance path, so that it favours the pass of the direct signal between the input BBSI and the output BBSO with respect to any alternative path.

In a serial type bypass block BBS in cut-off mode, the output BBSO is isolated from the input BBSI. Isolating is understood as preventing the signal present at the BBSI input from passing to the BBSO output.

A BBP parallel type bypass block has two modes of operation: a first mode of operation called passing mode and a second mode of operation called cut-off mode.

In a parallel type bypass block BBP in passing mode, a grounding path for the signal present at the input BBPI is enabled. Enabling a grounding path is understood in this context as establishing a very low impedance connection between the input BBPI and ground, favouring the pass of the signal with respect to any other alternative path.

In a parallel type bypass block BBP in cut-off mode, a connection is established between the BBPO output and the input BBPI. Connection in this case means enabling a low impedance path, so that it favours the passage of the direct signal between the BBPI input and the BBPO output with respect to any alternative path.

In Figure 2, the bypass module 3 contains at least three bypass blocks. Of these three bypass blocks, at least the first bypass block BB1 and at least the last bypass block BBr are of the first type of bypass block called serial bypass block BBS, and at least one bypass block BBk located between the first bypass block BB1 and the last bypass block BBr is of the second type called parallel bypass block BBP. First bypass block BB1 refers to that whose BB1l input is connected to the output of the input decoupling block BDIBI of the bypass module BDIB, and last bypass block BBr is understood as that whose output is connected to the input BDOBI of the output decoupling block of the bypass module BDOB.

Thus in FIG. 2, in order for the bypass module 3 to be in signal passing mode, all the serial bypass blocks BB1S, ..., BBrS must be in passing mode, and all parallel type bypass blocks BB2P, ..., BBr-1P must be in cut-off mode.

In another case, in order for the bypass module 3 to be in isolation mode, there must be
- at least one parallel type bypass block BB2P, ..., BBr-1P is in passing mode,
- at least one serial bypass block BB1S, ..., BBrS that is closer to the input of the bypass module 3l than the parallel type bypass block BB1P, ..., BBr-1P closest to the input of the bypass module 3l and which is in passing mode, is in cut-off mode, and that
- at least one serial bypass block BB1S, ..., BBrS which is closer to the output of the bypass module 30 than the parallel type bypass block BB1P, ..., BBr-1P closest to the output of the bypass module 30 and which is in passing mode, is in cut-off mode.

This is illustrated by an example such as that shown in Figure 4, in which a bypass module 3 is shown as described above consisting of a bypass input decoupling block BDIB, four serial type bypass modules BB1S, BB2S, BB4S and BB6S, two parallel type bypass blocks BB3P and BB5P, and one bypass output decoupling block BDOB.

In this case, for the bypass module 3 to be in signal passing mode, it is strictly necessary that the serial bypass blocks BB1S, BB2S, BB4S and BB6S be in passing mode and the parallel bypass blocks BB3P and BB5P be in cut-off mode.

On the other hand, in order for the bypass module 3 to be in isolation mode, the following conditions must be met:
1. If BB3P is in passing mode and BB5P is in cut-off mode, then at least BB1S or BB2S must be in cut-off mode and at least BB4S or BB6S must be in cut-off mode.
2. If BB3P is in cut-off mode and bypass block BB5P is in passing mode, at least BB1S or BB2S or BB4S must be in cut-off mode and BB6S must be in cut-off mode.
3. If both BB3P and BB5P are in passing mode, at least BB1S or BB2S must be in cut-off mode and BB6S must be in cut-off mode.

Fig. 5 shows a non-limiting example of the i-th amplification block BAi, where i is an integer comprised between 1 and n. This block contains
- a input BAil
- a output BAiO
- a PHEMT technology transistor TRBAi whose operating zone is controlled by a first control voltage Vcai1, a second control voltage Vcai2 and a third control voltage Vcai3 and having a gate terminal GTRBAi, a drain terminal DTRBAi and a source terminal STRBAi
- a drain capacitor CBADi connected by one of its terminals to the drain terminal DTRBAi of transistor TRBAi
- a source capacitor CBASi connected by one of its terminals to the source terminal STRBAi of the transistor TRBAi, and by another terminal to ground.

In this i-th amplification block according to figure 5
- the input BAil is the gate terminal of the transistor GTRBAi
- the BAiO output is a terminal of the drain capacitor CBADi not connected to the drain terminal DTRBAi of the transistor TRBAi
- the first control voltage Vcai1, the second control voltage Vcai2 and the third control voltage Vcai3 are control voltages Vc1, ..., Vs generated by the polarization network 4,
- the first control voltage Vcai1 is applied to the gate terminal GTRBAi of the transistor TRBAi,
- The second control voltage Vcai2 is applied to the drain terminal DTRBAi of the transistor TRBAi, and
- the third control voltage Vcai3 is applied to the source terminal STRBAi of the transistor TRBAi.

For this particular embodiment of the i-th amplification block BAi, in the amplification mode, the value of the first control voltage Vcai1, the value of the second control voltage Vcai2 and the value of the third control voltage Vca3 are such that the transistor TRBAi of the i-th amplification block BAi is polarized in the active zone.

In the cut-off mode, the value of the first control voltage Vcai1, the value of the second control voltage Vcai2 and the value of the third control voltage Vca3 are such that the transistor TRBAi of the i-th amplification block BAi is polarized in the cut-off zone.

As non-limiting examples of possible applied voltage values:
- For voltage values Vcai1 = 1,7V, Vca2 = 4V and Vca3 = 1, the transistor TRBAi is in active operating zone and the amplifier block BAi is in amplification mode.
- For voltage values Vcai1 = 0 V, Vca2 = 1V and Vca3 = 1V, the transistor TRBAi is in the cut-off operating zone and the amplifier block BAi is in cut-off mode.
- For voltage values Vcai1 = 0 V, Vca2 = 0V and Vca3 = 0V, the transistor TRBAi is in the cut-off operating zone, and the amplifier block BAi is in cut-off mode.

In case the value of Vca3 being zero volts, it is possible to dispense with the capacitor CBAiS.

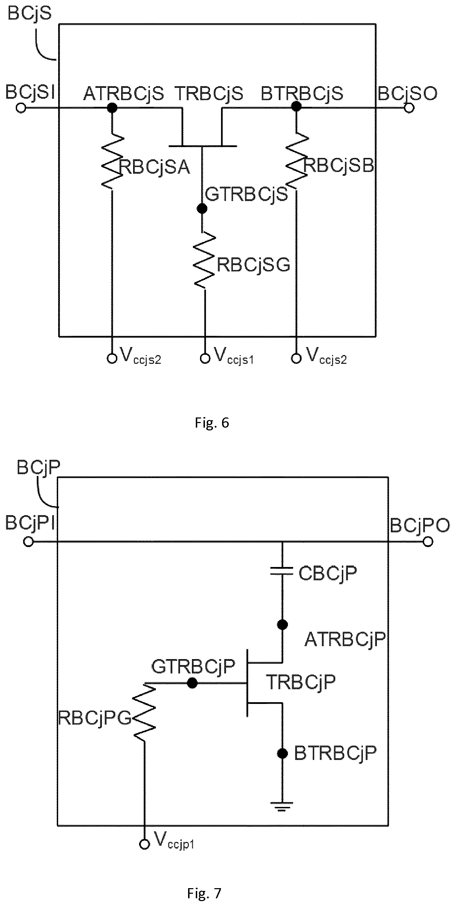

Figure 6 shows a non-limiting example of the j-th serial switching block (BCjS), where j is an integer number comprised between 1 and m. This block contains
- an input BCjSI,
- an output BCjSO,
- a PHEMT technology transistor TRBCjS whose operating zone is controlled by a first control voltage Vccjs1 and by a second control voltage Vccjs2, and which has a gate terminal GTRBCjS, an A terminal ATRBCjS and a B terminal BTRBCjS,
- a gate resistor RBCjSG connected by one of its terminals to the gate terminal GTRBCjS of the transistor TRBCjS,
- a resistor called A RBCjSA connected by one of its terminals to the A terminal ATRBCjS of the transistor TRBCjS, and
- a resistor called B RBCjSB connected by one of its terminals to the B terminal BTRBCjS of the transistor TRBCjS

In this j-th serial switching block according to figure 6
- the input BCjSI of the j-th serial switching block BCjS is the A terminal of the ATRBCjS amplifier
- the output BCSjO of the serial switching block BCjS is terminal B of the amplifier BTRBCjS
- The first control voltage Vccjs1 and the second control voltage Vccjs2 are control voltages Vc1, ..., Vcs generated by the polarization network 4,
- The first control voltage Vccjs1 is applied to a terminal of the so-called gate resistor RBCjSG not connected to the gate terminal GTRBCjS of the transistor TRBCjS, and
- The second control voltage Vccjs2 is applied to a resistor terminal A (RBCjSA) not connected to the A terminal ATRBCjS of the transistor TRBCjS and to a resistor terminal called B RBCSjB not connected to terminal B BTRBCjS of the transistor TRBCjS.

For this particular embodiment of the j-th serial switching block (BCjS), in the passing mode the value of the first control voltage Vccjs1 and the value of the second control voltage Vccjs2 are such that the transistor TRBCjS is polarized in linear zone.

In the cut-off mode, the value of the first control voltage Vccjs1 and the value of the second control voltage Vccjs2 are such that the transistor TRBCjS of the j-th switching block, of serial type BCjS, is polarized in a cut-off zone.

As non-limiting examples of possible applied voltage values:
- For voltage values Vccjs1 = 2V and Vccjs2 = 1V transistor TRBCjS is in the linear operating zone and the serial switching block BCjS is in passing mode.
- For voltage values Vccjs1 = 0V and Vccjs2 = 1V, the transistor TRBCjS is in the cut-off operating zone and the serial switching block BCjS is in cut-off mode.
- For voltage values Vccjs1 = 0 V, Vccjs2 = 0 V, the transistor TRBCjS is in the cut-off operating zone and the serial switching block BCjS is in cut-off mode.

The A terminal ATRBCjS of the transistor TRBCjS may correspond either to the drain terminal of the transistor or to the source terminal of the transistor, in which case B terminal BTRBCjS will respectively correspond to the source terminal of the transistor or to the drain terminal of transistor TRBCjS.

Figure 7 shows a non-limiting example of the j-th parallel switching block BCjP, where j is an integer comprised between 1 and m. This block contains:
- A input BCjPI,
- A output BCjPO,
- A PHEMT technology transistor TRBCP whose operating zone is controlled by a control voltage Vccjp1 and which has a gate terminal GTRBCjP, an A terminal ATRBCjP, and a B terminal BTRBCjP connected to ground,
- a gate resistor RBCjPG connected by one of its terminals to the gate terminal of the transistor GTRBCjP and
- a drain capacitor CBCjP connected by one of its terminals to the A terminal ATRBCjP of the transistor TRBCjP

In this j-th parallel switching block according to figure 7
- The BCjPI input and the BCjPO output of the parallel switching block BCjP are a terminal of the capacitor CBCjP not connected to the A terminal ATRBCjP of the transistor TRBCjP
- The control voltage Vccjp1 is one of the control voltages Vc1, ..., Vcs generated by the polarization network 4, and
- The control voltage Vccjp1 is applied to a gate resistor terminal (RBCjPG) not connected to the gate terminal GTRBCjP of the transistor TRBCjP

For this particular embodiment of the j-th parallel switching block BCjP, in the passing mode the value of the control voltage Vccjp1 is such that the transistor TRBCjP is polarized in linear zone.

In the cut-off mode, the value of the control voltage Vccjp1 is such that the transistor TRBCjP of the j-th switching block, of parallel type BCjP, is polarized in a cut-off zone.

As non-limiting examples of possible applied voltage values:
- For voltage values Vccjp1 = -2V the transistor TRBCjP is in the linear operating zone and the parallel switching block BCjP is in the cut-off mode.
- For voltage values Vccjp1 = 0V, the transistor TRBCjP is in the cut-off operating zone and the parallel switching block BCjP is in passing mode.

The A terminal ATRBCjP of the transistor TRBCjP may correspond either to the drain terminal of the transistor or to the source terminal of the transistor, in which case B terminal BTRBCjP will respectively correspond to the source terminal of the transistor or to the drain terminal of transistor TRBCjP.

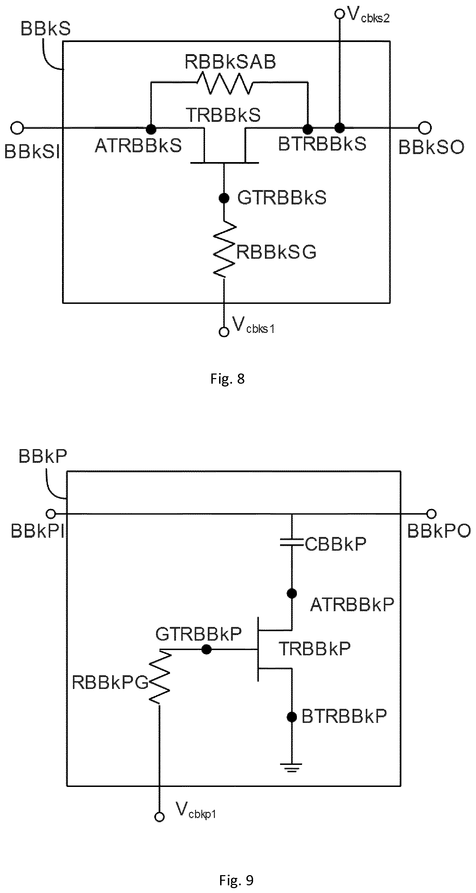

Figure 8 shows a non-limiting example of the k-th serial bypass block BBkS, where k is an integer comprised between 1 and r. This block contains
- a input BBkSI,
- A output BBkSO,
- A PHEMT technology transistor TRBBkS whose operating zone is controlled by a first control voltage Vcbks1 and a second control voltage Vcbks2, and having a gate terminal (GTRBBkS), an A terminal (ATRBBkS) and a B Terminal (BTRBBkS),
- A gate resistor (RBBSkG) connected by one of its terminals to the gate terminal GTRBBkS of the transistor TRBBkS and
- A resistor referred to as AB RBBkSAB connected by one of its terminals to the A terminal ATRBBkS of the transistor TRBBkS and to the B terminal BTRBBkS of the transistor TRBBkS

In this k-th serial switching block according to figure 8
- The input BBkSI is the A terminal ATRBBkS of the transistor TRBBkS,
- The output BBkSO is the B terminal BTRBBkS of the transistor TRBBkS,
- The first control voltage Vcbks1 and the second control voltage Vcbks2 are control voltages Vc1, ..., Vcs generated by the polarization network 4,
- The first control voltage Vcbks1 is applied to a gate resistor terminal RBBkSG not connected by one of its terminals to the gate terminal GTRBBkS of the transistor TRBBkS, and
- The second control voltage (Vcbks2) is applied to the B terminal BTRBBkS of the transistor TRBBkS

For this particular embodiment of the k-th serial bypass block BBkS, in the passing mode the value of the first control voltage Vcbks1 and the value of the second control voltage Vcbks2 are such that the transistor TRBBkS is polarized in linear zone.

In the cut-off mode, the value of the first control voltage Vcbks1 and the value of the second control voltage Vcbks2 are such that the transistor TRBBkS is polarized in a cut-off zone.

As non-limiting examples of possible applied voltage values:
- For voltage values Vcbks1 = 2V and Vcbks2 = 1V the transistor TRBBkS is in the linear operating zone and the serial bypass block BBkS is in passing mode.
- For voltage values Vcbks1 = 0V and Vcbks2 = 0V the transistor TRBBkS is in the cut-off operating zone and the BBkS serial by-pass block is in passing mode.
- For voltage values Vcbks1 = 0V and Vcbks2 = 3V the transistor TRBBkS is in the cut-off operating zone and the BBkS serial bypass block BBkS is in cut-off mode.

The A terminal ATRBBkS of the transistor TRBBkS may correspond either to the drain terminal of the transistor or to the source terminal of the transistor, in which case the B terminal BTRBBkS will respectively correspond to the source terminal of the transistor or to the drain terminal of the transistor TRBBkS.

Figure 9 shows a non-limiting example of the k-th parallel bypass block BBkP, where k is an integer comprised between 1 and r. This block contains:
- A input BBkPI,
- A output BBkPO,
- a PHEMT technology transistor TRBBkP whose operating zone is controlled by a control voltage Vcbkp1, and which has a gate terminal GTRBBkP, an A terminal ATRBBkP and a B terminal BTRBBkP connected to ground,
- a gate resistor RBBkPG connected by one of its terminals to the gate terminal GTRBBk of the transistor TRBBk and
- a capacitor CBBkP connected by one of its terminals to the A terminal ATRBBkP of the transistor TRBBkP

In this k-th parallel switching block according to FIG. 9
- the input BBkPI and the output BBkPO of the parallel bypass block BBkP are a terminal of the capacitor CBBkP not connected to the A terminal ATRBBkP of the transistor TRBBkP
- the control voltage Vcbkp1 is a control voltage Vc1, ..., Vcs generated by the polarization network 4 and
- the control voltage Vcbkp1 is applied to a gate resistor terminal RBBkPG not connected to the gate terminal GTRBBkP of transistor TRBBkP.

For this particular embodiment of the k-th parallel bypass block BBkP, in the passing mode the value of the control voltage Vcbkp1 is such that the transistor TRBBkP is polarized in a linear zone.

In the cut-off mode the value of the first control voltage Vcbkp1 is such that the transistor TRBBkP is polarized in the cut-off zone.

As non-limiting examples of possible applied voltage values:
- For voltage values Vcbkp1 = 1V the transistor TRBBkP is in the linear operating zone and the parallel bypass block BBkP is in passing mode.
- For voltage values Vcbkp1 = 0V the transistor TRBBkP is in the cut-off operating zone and the parallel bypass block BBkP is in cut-off mode.

The A terminal ATRBBkP of the transistor TRBBkP may correspond either to the drain terminal of the transistor or to the source terminal of the transistor, in which case the B terminal BTRBBkP will respectively correspond to the source terminal of the transistor or to the drain terminal of the transistor TRBBkP.

In another embodiment of the amplification system SA, the transistor TRBCjS of the j-th serial-type switching block BCjS shown in Figure 6 is of the enhancement type for any integer value of j comprised between 1 and m, the transistor TRBCjP of the j-th parallel type switching block BCjP shown in Figure 7 is depletion type for any integer value of j comprised between 1 and m, the transistor TRBBkS of the k-th serial type bypass block BBkS shown in Figure 8 is depletion type for any integer value of k comprised between 1 and r, and the transistor TRBBkS of the k-th parallel type switching block BBkP shown in FIG. 9 is of enhancement type, for any integer value of k comprised between 1 and r.

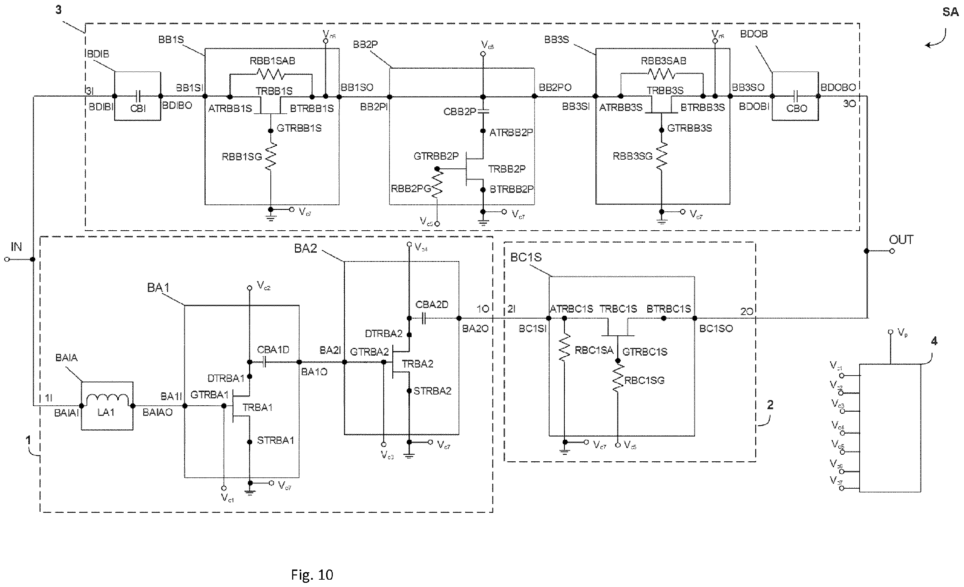

In another embodiment of the amplification system SA according to figure 10
- the input adaptation block of the amplification module BAIA is an inductance LA1, the input BAIAI of the input adaptation block of the amplification module BAIA being one of the terminals of the inductance LA1, and the output BAIAO of the input adaptation block of the amplification module BAIA being another of the terminals of the inductance LA1,
- the amplification module 1 contains exactly two amplification blocks BA1 and BA2,
- The output adaptation block of the amplification module BAOA is a connection line
- The switching module 2 contains exactly one switching block BC1 of the first type of switching block called serial switching block BC1S, within which the resistor of the B terminal RBC1SG is suppressed,
- The input decoupling block of the bypass module BDIB is an input decoupling capacitor CBI, the input BDIBI of the input decoupling block of the bypass module BDIB being one of the terminals of the input decoupling capacitor CBI, and the output BDIBO of the input decoupling block of the bypass module BDIB, being another of the terminals of the input decoupling capacitor CBI
- The bypass module 3 contains a first bypass block BB1, a second bypass block BB2 and a third bypass block BB3, the first block BB1 and the third block BB3 being of the first type of bypass block called serial bypass block BB1S and BB3S, and the second block BB2 being of the second type of bypass block called parallel bypass block BB2P
- and
- The output decoupling block of the bypass module BDOB is an output decoupling capacitor CBO, the BDOBI input of the output decoupling block of the bypass module BDOB being one of the output decoupling capacitor terminals CBO, and the BDOBO output of the output decoupling block of the bypass module BDOB being another of the terminals of the output decoupling capacitor CBO.

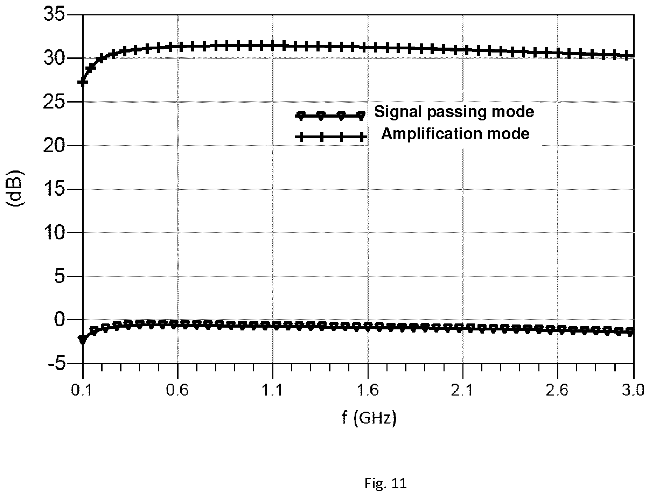

Figure 11 shows the response of the embodiment of the amplification system according to this embodiment. As can be seen, the amplification mode achieves a gain of more than 30 dBs, while in signal passing mode the insertion losses are reduced to below 2 dBs.

These characteristics of gain / insertion loss can be adapted to specific requirements simply by including additional blocks in the amplification and/or switching and/or bypass modules.

### LIST OF REFERENCES

- SA: Amplifier system
- IN: Input of the amplifier system
- OUT: Output of the amplifier system
- 1: Amplification module
- 1I: Input of the amplification module
- 1O: Output of the amplification module
- 2: Switching module
- 2I: Input of the switching module
- 2O: Output of the switching module
- 3: Bypass module
- 3I: Bypass module input
- 3O: Bypass module output
- 4: Polarization network
- Vcc: Input Voltage
- Vc1,..., Vcs: Control voltage

- BAIA: Input adaptation block of the amplification module
- BAIAI: Input of the input adaptation block of the amplification module
- BAIAO: Output of the input adaptation block of the amplification module
- LA1: Amplification Module Inductance
- BAOA: Output adaptation block of the amplification module
- BAOAI: Input of the output adaptation block of the amplification module
- BAOAO: Output of the output adaptation block of the amplification module
- BA1,..., BAn: Amplification block 1, ..., n
- BA1I, ..., BAnI: Input of the amplification block 1, ..., n
- BA1O,..., BAnO: Output of the amplification block 1, ..., n

- BAi: i-th amplification block
- BAiI: Input of the i-th amplification block
- BAiO: Output of the i-th amplification block
- TRBAi: Transistor of the i-th amplification block
- GTRBAi: Gate terminal of the transistor of the i-th amplification block
- DTRBAi: Drain terminal of the transistor of the i-th amplification block
- STRBAi: Source terminal of transistor of the i-th amplification block
- CBADi: Drain capacitor of the i-th amplification block
- CBASi: Source capacitor of the i-th amplification block.
- Vcai1, Vcai2,: Control voltages of the operating zone of the TRBAi transistor of the i-th
- Vcai3: amplification block
- BDIB: Input decoupling block of the bypass module
- BDIBI: Input of the input bypass block of the bypass module
- BDIBO: Output of the input bypass block of the bypass module
- CBI: Input decoupling capacitor of the bypass module
- BDOB: Output decoupling block of the bypass module
- BDOBI: Input of the output decoupling block of the bypass module
- BDOBO: Output of the output decoupling block of the bypass module
- CBO: Output decoupling capacitor of the bypass module

- BC1,...,BCm: Switching block 1, ..., m
- BC1I,...,BCmI: Input of switching block 1, ..., m
- BC1O, ..., BCmO: Output of switching block 1, ..., m
- BCj: J-th control block
- BCjI: Input of the j-th control block
- BCjO: Output of the j-th control block

- BCS: Generic serial switching block
- BCSI: Input of generic serial type switching block
- BCSO: Output of generic serial type switching block
- BCjS: j-th switching block, serial type
- BCjSI: Input of the j-th switching block, serial type
- BCjSO: Output of the j-th switching block, serial type
- TRBCjS: Transistor of the j-th switching block, serial type
- GTRBCjS: Transistor gate terminal of the j-th switching block, serial type
- ATRBCjS: Terminal A of the transistor of the j-th switching block, serial type
- BTRBCjS: Terminal B of the transistor of the j-th switching block, serial type
- RBCjSG: Gate resistor of the j-th switching block, serial type
- RBCjSA: Terminal A resistor of the j-th switching block, serial type
- RBCjSB: Terminal B resistor of the j-th switching block, serial type
- Vccjs1, Vccjs2,: Control voltage of the operating zone of the transistor TRBCjS of the j-th switching
- Vccjs3: block, serial type

- BCP: Generic parallel switching block
- BCPI: Input of the generic parallel type switching block
- BCPO: Output of the generic parallel type switching block
- BCjP: j-th switching block, parallel type
- BCjPI: Input of the j-th switching block, parallel type
- BCjPO: Output of the j-th switching block, parallel type
- TRBCjP: Transistor of the j-th switching block, parallel type
- GTRBCjP: Gate terminal of the transistor of the j-th switching block, parallel type
- ATRBCjP: Terminal A of the transistor of the j-th switching block, parallel type
- BTRBCjP: Terminal B of the transistor of the j-th switching block, parallel type
- RBCjPG: Gate resistor of the j-th switching block, parallel type
- CBCjP: Capacitor of the j-th switching block, parallel type
- Vccjp1: Control voltage of the operating zone of the transistor TRBCjP of the j-th switching block, parallel type

- BB1,...,BBr: Bypass block 1, ..., r
- BB1I,...,BBrI: Input of bypass block 1, ..., r
- BB1O,...,BBrO: Output of bypass block 1, ..., r
- BBk: k-th bypass block
- BBkI: Input of the k-th bypass block
- BBkO: Output of the k-th bypass block

- BBkS: k-th switching block, serial type
- BBkSI: Input of the k-th bypass block, serial type
- BBkSO: Output of the k-th bypass block, serial type
- TRBBkS: Transistor of the k-th bypass block, serial type
- GTRBBkS: Gate terminal of the transistor of the k-th bypass block, serial type
- ATRBBkS: Terminal A of the transistor of the k-th bypass block, serial type
- BTRBBkS: Terminal B of the transistor of the k-th bypass block, serial type
- RBBkSG: Gate resistor of the k-th bypass block, serial type
- RBBSkSAB: Resistor A-B of the k-th bypass block, serial type

- BBkP: k-th bypass block, parallel type
- BBkPI: Input of the k-th bypass block, parallel type
- BBkPO: Output of the k-th bypass block, parallel type
- TRBBkP: Transistor of the k-th bypass block, parallel type
- GTRBBkP: Transistor gate of the k-th bypass block, parallel type
- ATRBBkP: Terminal A of the transistor of the k-th bypass block, parallel type
- BTRBBkP: Terminal B of the transistor of the k-th bypass block, parallel type
- RBBkPG: Gate resistor of the k-th bypass block, parallel type
- CBBkP: Capacitor of the k-th bypass block, parallel type

## Claims

1. Telecommunication signal amplification system (SA), in particular for the amplification of radio, television and/or data signals, comprising
- An input (IN), for the telecommunication signal, of the telecommunication signal amplification system (SA).
- An output (OUT), for the telecommunication signal, of the telecommunication signal amplification system (SA).
- An amplification module (1), with an input of the amplification module (1I) and an output of the amplification module (1O), which is configured in such a way as to have two modes of operation, a first mode called amplification mode of the amplification module and a second mode called cut-off mode of the amplification module.
- A switching module (2) with an input of the switching module (2I) and an output of the switching module (2O), which is configured in such a way as to have two modes of operation, a first mode called signal passing mode of the switching module and a second mode called isolation mode of the switching module.
- A bypass module (3) with an input of the bypass module (3I) and an output of the bypass module (3O), which is configured in such a way as to have two modes of operation, a first mode called signal passing mode of the bypass module and a second mode called isolation mode of the bypass module.
- An input voltage (Vp),
- A polarization network (4) configured to generate from the input voltage (Vp) at least one control voltage value (Vc1,..., Vcs)
wherein
- the amplification module (1) in amplification mode of the amplification module is configured to set at the output (1O) of the amplification module (1) the amplified version of the signal present at the input (1I) of the amplification module (1),
- the amplification module (1) in cut-off mode of the amplification module is configured to isolate the output (1O) of the amplification module (1) at the input (1I) of the amplification module (1),
- the switching module (2) in signal passing mode of the switching module is configured to connect the output (2O) of the switching module (2) to the input (1I) of the switching module (2),
- the switching module (2) in isolation mode of the switching module is configured to isolate the output (2O) of the switching module (2) from the input (1I) of the switching module (2),
- the bypass module (3) in signal passing mode of the bypass module is configured to connect the output (3O) of the bypass module (3) to the input (3I) of the bypass module (3)
- the bypass module (3) in isolation mode of the bypass module is configured to isolate the output (30) of the bypass module (3) from the input (3I) of the bypass module (3)
- the input (1I) of the amplification module (1) is connected to the input (31) of the bypass module (3), constituting the input (IN) of the telecommunication signal amplification system (SA),
- the output (1O) of the amplification module (1) is connected to the input (2I) of the switching module (2),
- the output (2O) of the switching module (2) is connected to the output (3O) of the bypass module 3, constituting the output (OUT) of the telecommunication signal amplification system (SA),
- the said amplification system (SA) is configured to have a first mode of operation of the amplification system and a second mode of operation of the amplification system selectable depending on the at least one control voltage value (Vc1, ..., Vcs)
wherein
- in the first mode of operation of the amplification system, called amplification mode of the amplification system, the amplification module (1) is in amplification mode of the amplification module, the switching module (2) is in signal passing mode of the switching module (2) and the bypass module (3) is in isolation mode of the bypass module, and the telecommunication signal at the input (IN) of the amplification system (SA) is amplified through the amplification module (1) and said amplified telecommunication signal is set to the output (OUT) of the amplification system (SA) through the switching module (2) and
- In the second mode of operation of the amplification system, called signal passing mode of the amplification system (SA), the bypass module (3) is in signal passing mode of the bypass module (3), the amplification module (1) is in cut-off mode of the amplification module and the switching module (2) is in isolation mode of the switching module, and the telecommunication signal at the input (IN) of the amplification system (SA) is not amplified and is set to the output (OUT) of the amplification system (SA) through the bypass module (3),
- the said amplification system (SA) is configured to be in signal passing mode of the amplification system (SA) if the at least one control voltage value (Vc1, ..., Vcs) is equal to zero volts, making the amplification system a passive system that does not need external power supply,
- the bypass module (3) comprises at least one bypass block, having an input of the at least one bypass block and an output of the at least one bypass block configured to have a first mode of operation of the at least one bypass block and a second mode of operation of the at least one bypass block wherein the first mode of operation of the at least one bypass block and the second mode of operation of the at least one bypass block are controlled by the at least one control voltage value (Vc1, ..., Vcs),
wherein
- in the first mode of operation of the at least one bypass block, called signal passing mode of the at least one bypass block, a connection is established between the output of the at least one bypass block and the input of the at least one bypass block,
- in the second mode of operation of the at least one bypass block, called cut-off mode of the at least one bypass block the output of the at least one bypass block is isolated from the input of the at least one bypass block.
- the amplification module comprises at least one amplification block wherein the at least one amplification block comprises a first amplification block (BA1) wherein the first amplification block (BA1) comprises at least one transistor
wherein
- if the amplification system is in amplification mode of the amplification system (SA), the at least one transistor is configured to amplify the telecommunication signal at the input (IN) of the telecommunication signal amplification system (SA) present at an input of the at least one transistor,
- if the amplification system is in bypass mode of the amplification system (SA), the at least one transistor is configured to be cut-off and the telecommunication signal at the input (IN) of the telecommunication signal amplification system (SA) is present at the input of the at least one transistor.

2. System according to claim 1, **characterized in that**
- in the signal passing mode of the bypass module (3), all of the at least one bypass block are in passing mode of the at least one bypass block,
and
- in the isolation mode of the bypass module (3), at least one bypass block of the at least one bypass block is in cut-off mode of the at least one bypass block.

3. System according to the preceding claims **characterized in that**
- the at least one amplification block having an input and an output, wherein the at least one amplification block is configured to have a first mode of operation and a second mode of operation wherein the first mode of operation and the second mode of operation are controlled by the at least one control voltage (Vc1, ..., Vcs)
wherein
- In the first mode of operation of the at least one amplification block, called amplification mode of the at least one amplification block, the at least one amplification block is configured to amplify the signal present at the input of the at least one amplification block and set the signal amplified at the output of the at least one amplification block,
and
- in the second mode of operation of the at least one amplification block, called cut-off mode of the at least one amplification block, the at least one amplification block is configured to isolate the output of the at least one amplification block from the input of the at least one amplification block,
and/or
- the switching module (2) comprises at least one switching block, the at least one switching block having an input and an output wherein the at least one switching block is configured to have a first mode of operation and a second mode of operation wherein the first mode of operation and the second mode of operation are controlled by the at least the control voltage (Vc1, ..., Vcs),
wherein
- in the first mode of operation of the at least one switching block, called signal passing mode of the at least one switching block, a connection is established between the output of the at least one switching block and the input of the at least one switching block
- in the second mode of operation of the at least one switching block, called cut-off mode of the at least one switching block, the output of the at least one switching block is isolated from the input of the at least one switching block,.

4. System according to claim 3 **characterized in that**
- in the amplification mode of the amplification module (1), all of the at least one amplification block are in amplification mode
and
- in the cut-off mode of the amplification module (1), at least the first amplification block (BA1) of the at least one amplification block is in cut-off mode

5. System according to clauses 3 and 4 **characterized in that**
- in the signal passing mode of the switching module (2), all of the at least one switching blocks are in passing mode,
and
- in the isolation mode of the switching module (2), at least one switching block of the at least one switching block is in cut-off mode.

## Patentansprüche

1. Telekommunikationssignalverstärkungssystem (SA), insbesondere zur Verstärkung von Radio-, Fernseh- und/oder Datensignalen, umfassend
- einen Eingang (IN), für das Telekommunikationssignal des Telekommunikationssignalverstärkungssystems (SA).
- einen Ausgang (OUT), für das Telekommunikationssignal des Telekommunikationssignalverstärkungssystems (SA).
- ein Verstärkermodul (1), mit einem Eingang des Verstärkermoduls (1I) und einem Ausgang des Verstärkermoduls (1O), das so konfiguriert ist, dass es zwei Betriebsarten aufweist, eine erste Betriebsart, die als Verstärkermodus des Verstärkermoduls bezeichnet wird, und eine zweite Betriebsart, die als Abschaltmodus des Verstärkermoduls bezeichnet wird.
- ein Schaltmodul (2) mit einem Eingang des Schaltmoduls (2I) und einem Ausgang des Schaltmoduls (2O), das so konfiguriert ist, dass es zwei Betriebsarten aufweist, eine erste Betriebsart, die als Signaldurchlassmodus des Schaltmoduls bezeichnet wird, und eine zweite Betriebsart, die als Isolationsmodus des Schaltmoduls bezeichnet wird.
- ein Bypass-Modul (3) mit einem Eingang des Bypass-Moduls (3I) und einem Ausgang des Bypass-Moduls (3O), das so konfiguriert ist, dass es zwei Betriebsarten aufweist, eine erste Betriebsart, die als Signaldurchlassmodus des Bypass-Moduls bezeichnet wird und eine zweite Betriebsart, die als Isolationsmodus des Bypass-Moduls bezeichnet wird.
- eine Eingangsspannung (Vp),
- ein Polarisationsnetzwerk (4), das so konfiguriert ist, dass es aus der Eingangsspannung (Vp) mindestens einen Steuerspannungswert (Vc1, ..., Vcs) erzeugt,
wobei
- das Verstärkermodul (1) im Verstärkermodus des Verstärkermoduls so konfiguriert ist, dass es am Ausgang (1O) des Verstärkermoduls (1) die verstärkte Version des am Eingang (1I) des Verstärkermoduls (1) anliegenden Signals einstellt,
- das Verstärkermodul (1) im Abschaltmodus des Verstärkermoduls so konfiguriert ist, dass der Ausgang (1O) des Verstärkermoduls (1) am Eingang (1I) des Verstärkermoduls (1) isoliert ist,
- das Schaltmodul (2) im Signaldurchlassmodus des Schaltmoduls so konfiguriert ist, dass es den Ausgang (2O) des Schaltmoduls (2) mit dem Eingang (1I) des Schaltmoduls (2) verbindet,
- das Schaltmodul (2) im Isolationsmodus des Schaltmoduls so konfiguriert ist, dass der Ausgang (2O) des Schaltmoduls (2) vom Eingang (1I) des Schaltmoduls (2) isoliert ist,
- das Bypass-Modul (3) im Signaldurchlassmodus des Bypass-Moduls so konfiguriert ist, dass es den Ausgang (3O) des Bypass-Moduls (3) mit dem Eingang (3I) des Bypass-Moduls (3) verbindet,
- das Bypass-Modul (3) im Isolationsmodus des Bypass-Moduls so konfiguriert ist, dass der Ausgang (3O) des Bypass-Moduls (3) vom Eingang (3I) des Bypass-Moduls (3) isoliert ist,
- der Eingang (1I) des Verstärkermoduls (1) mit dem Eingang (3I) des Bypass-Moduls (3) verbunden ist, wodurch der Eingang (IN) des Telekommunikationssignalverstärkungssystems (SA) gebildet wird,
- der Ausgang (1O) des Verstärkermoduls (1) mit dem Eingang (2I) des Schaltmoduls (2) verbunden ist,
- der Ausgang (2O) des Schaltmoduls (2) mit dem Ausgang (3O) des Bypass-Moduls 3 verbunden ist, wodurch der Ausgang (OUT) des Telekommunikationssignalverstärkungssystems (SA) gebildet wird,
- das Verstärkersystem (SA) so konfiguriert ist, dass es eine erste Betriebsart des Verstärkersystems und eine zweite Betriebsart des Verstärkersystems aufweist, die in Abhängigkeit von dem mindestens einen Steuerspannungswert (Vc1, ..., Vcs) wählbar ist,
wobei
- in der ersten Betriebsart des Verstärkersystems, die als Verstärkermodus des Verstärkersystems bezeichnet wird, ist das Verstärkermodul (1) im Verstärkermodus des Verstärkermoduls, das Schaltmodul (2) ist im Signaldurchlassmodus des Schaltmoduls (2) und das Bypass-Modul (3) ist im Isolationsmodus des Bypass-Modul, und das Telekommunikationssignal am Eingang (IN) des Verstärkersystems (SA) durch das Verstärkermodul (1) verstärkt wird und dieses verstärkte Telekommunikationssignal durch das Schaltmodul (2) auf den Ausgang (OUT) des Verstärkersystems (SA) gesetzt wird und
- in der zweiten Betriebsart des Verstärkersystems, die als Signaldurchlassmodus des Verstärkersystems (SA) bezeichnet wird, ist das Bypass-Modul (3) im Signaldurchlassmodus des Bypass-Moduls (3), das Verstärkermodul (1) ist im Abschaltmodus des Verstärkermoduls und das Schaltmodul (2) ist im Isolationsmodus des Schaltmoduls, und das Telekommunikationssignal am Eingang (IN) des Verstärkersystems (SA) nicht verstärkt wird und durch das Bypass-Modul (3) auf den Ausgang (OUT) des Verstärkersystems (SA) gesetzt wird,
- das Verstärkersystem (SA) so konfiguriert ist, dass es sich im Signaldurchlassmodus des Verstärkersystems (SA) befindet, wenn der mindestens eine Steuerspannungswert (Vc1, ..., Vcs) gleich null Volt ist, wodurch das Verstärkersystem ein passives System ist, das keine externe Stromversorgung benötigt,
- das Bypass-modul (3) mindestens einen Bypass-Block umfasst, worin ein Eingang des mindestens einen Bypass-Blocks und ein Ausgang des mindestens einen Bypass-Blocks so konfiguriert sind, dass sie eine erste Betriebsart des mindestens einen Bypass-Blocks und eine zweite Betriebsart des mindestens einen Bypass-Blocks aufweisen, wobei die erste Betriebsart des mindestens einen Bypass-Blocks und die zweite Betriebsart des mindestens einen Bypass-Blocks durch den mindestens einen Steuerspannungswert (Vc1, ..., Vcs) gesteuert werden,
wobei
- in der ersten Betriebsart des mindestens einen Bypass-Blocks, die als Signaldurchlassmodus des mindestens einen Bypass-Blocks bezeichnet wird, eine Verbindung zwischen dem Ausgang des mindestens einen Bypass-Blocks und dem Eingang des mindestens einen Bypass-Blocks hergestellt wird,
- in der zweiten Betriebsart des mindestens einen Bypass-Blocks, die als Abschaltmodus des mindestens einen Bypass-Blocks bezeichnet wird, der Ausgang des mindestens einen Bypass-Blocks vom Eingang des mindestens einen Bypass-Blocks isoliert ist.
- das Verstärkermodul mindestens einen Verstärkerblock umfasst, wobei der mindestens eine Verstärkerblock einen ersten Verstärkerblock (BA1) umfasst, wobei der erste Verstärkerblock (BA1) mindestens einen Transistor umfasst,
wobei
- wenn sich das Verstärkersystem im Verstärkermodus des Verstärkersystems (SA) befindet, der mindestens eine Transistor so konfiguriert ist, dass er das Telekommunikationssignal am Eingang (IN) des Telekommunikationssignalverstärkungssystems (SA) verstärkt, das an einem Eingang des mindestens einen Transistors anliegt,
- wenn sich das Verstärkersystem im Bypass-Modus der Verstärkersystem (SA) befindet, der mindestens eine Transistor zum Abschalten konfiguriert ist, und das Telekommunikationssignal am Eingang (IN) der Telekommunikationssignalverstärkungsanlage (SA) am Eingang des mindestens einen Transistors anliegt.

2. System nach Anspruch 1, **dadurch gekennzeichnet, dass**
- sich in dem Signaldurchlassmodus des Bypass-Moduls (3) alle des mindestens einen Bypass-Blocks im Durchlassmodus des mindestens einen Bypass-Blocks befinden,
und
- sich im Isolationsmodus des Bypass-moduls (3) mindestens ein Bypass-Block des mindestens einen Bypass-Blocks im Abschaltmodus des mindestens einen Bypass-Blocks befindet.

3. System nach den vorherigen Ansprüchen, **dadurch gekennzeichnet, dass**
- der mindestens eine Verstärkerblock einen Eingang und einen Ausgang aufweist, wobei der mindestens eine Verstärkerblock so konfiguriert ist, dass er eine erste Betriebsart und eine zweite Betriebsart aufweist, wobei die erste Betriebsart und die zweite Betriebsart durch die mindestens eine Steuerspannung (Vc1, ..., Vcs) gesteuert werden,
wobei
- in der ersten Betriebsart des mindestens einen Verstärkerblocks, die als Verstärkermodus des mindestens einen Verstärkerblocks bezeichnet wird, der mindestens eine Verstärkerblock so konfiguriert ist, dass er das am Eingang des mindestens einen Verstärkerblocks anliegende Signal verstärkt und das am Ausgang des mindestens einen Verstärkerblocks verstärkte Signal einstellt,
und
- in der zweiten Betriebsart des mindestens einen Verstärkerblocks, die als Abschaltmodus Modus des mindestens einen Verstärkerblocks bezeichnet wird, der mindestens eine Verstärkerblock so konfiguriert ist, dass der Ausgang des mindestens einen Verstärkerblocks vom Eingang des mindestens einen Verstärkerblocks isoliert ist,
und/oder
- das Schaltmodul (2) mindestens einen Schaltblock umfasst, worin der mindestens eine Schaltblock einen Eingang und einen Ausgang aufweist, wobei der mindestens eine Schaltblock so konfiguriert ist, dass er eine erste Betriebsart und eine zweite Betriebsart aufweist, wobei die erste Betriebsart und die zweite Betriebsart durch die mindestens eine Steuerspannung (Vc1, ..., Vcs) gesteuert werden,
wobei
- in der ersten Betriebsart des mindestens einen Schaltblocks, die als Signaldurchlassmodus des mindestens einen Schaltblocks bezeichnet wird, eine Verbindung zwischen dem Ausgang des mindestens einen Schaltblocks und dem Eingang des mindestens einen Schaltblocks hergestellt wird
- in der zweiten Betriebsart des mindestens einen Schaltblocks, die als Abschaltmodus des mindestens einen Schaltblocks bezeichnet wird, der Ausgang des mindestens einen Schaltblocks vom Eingang des mindestens einen Schaltblocks isoliert ist.

4. System nach Anspruch 3, **dadurch gekennzeichnet, dass**
- sich im Verstärkermodus des Verstärkermoduls (1) alle des mindestens einen Verstärkerblocks im Verstärkermodus befinden
und
- sich im Abschaltmodus des Verstärkermoduls (1) mindestens der erste Verstärkerblock (BA1) des mindestens einen Verstärkerblocks im Abschaltmodus befindet

5. System nach den Klauseln 3 und 4, **dadurch gekennzeichnet, dass**
- sich im Signaldurchlassmodus des Schaltmoduls (2) alle der mindestens einen Schaltblöcke im Durchlassmodus befinden,
und
- sich im Isolationsmodus des Schaltmoduls (2) mindestens ein Schaltblock des mindestens einen Schaltblocks im Abschaltmodus befindet.

## Revendications

1. Système d'amplification de signal de télécommunication (SA), en particulier pour l'amplification de signaux de radio, de télévision et/ou de données, comprenant
- Une entrée (IN), pour le signal de télécommunication, du système d'amplification de signal de télécommunication (SA).
- Une sortie (OUT), pour le signal de télécommunication, du système d'amplification de signal de télécommunication (SA).
- Un module d'amplification (1), avec une entrée du module d'amplification (1I) et une sortie du module d'amplification (1O), configuré avec deux modes de fonctionnement : un premier mode appelé mode amplification du module d'amplification, et un second mode appelé mode coupure du module d'amplification.
- Un module de commutation (2) avec une entrée du module de commutation (2I) et une sortie du module de commutation (2O), configuré avec deux modes de fonctionnement, un premier mode appelé mode passage de signal du module de commutation, et un second mode appelé mode isolation du module de commutation.
- Un module bypass (3) avec une entrée du module bypass (3I) et une sortie du module bypass (3O), configuré avec deux modes de fonctionnement, un premier mode appelé mode passage de signal du module bypass et un second mode appelé mode isolation du module bypass.
- Une tension d'entrée (Vp),
- Un réseau de polarisation (4) configuré pour générer à partir de la tension d'entrée (Vp) au moins une valeur de tension de commande (Vc1, ..., Vcs)
dans lequel
- le module d'amplification (1) en mode amplification du module d'amplification est configuré pour régler à la sortie (1O) du module d'amplification (1) la version amplifiée du signal présent à l'entrée (1I) du module d'amplification (1),
- le module d'amplification (1) en mode coupure du module d'amplification est configuré pour isoler la sortie (1O) du module d'amplification (1) à l'entrée (1I) du module d'amplification (1),
- le module de commutation (2) en mode passage de signal du module de commutation est configuré pour raccorder la sortie (2O) du module de commutation (2) à l'entrée (1I) du module de commutation (2),
- le module de commutation (2) en mode isolation du module de commutation est configuré pour isoler la sortie (2O) du module de commutation (2) de l'entrée (1I) du module de commutation (2),
- le module bypass (3) en mode passage de signal du module bypass est configuré pour raccorder la sortie (3O) du module bypass (3) à l'entrée (3I) du module bypass (3)
- le module bypass (3) en mode isolation du module bypass est configuré pour isoler la sortie (3O) du module bypass (3) de l'entrée (3I) du module bypass (3)
- l'entrée (1I) du module d'amplification (1) est raccordée à l'entrée (3I) du module bypass (3), constituant l'entrée (IN) du système d'amplification de signal de télécommunication (SA),
- la sortie (1O) du module d'amplification (1) est raccordée à l'entrée (2I) du module de commutation (2),
- la sortie (2O) du module de commutation (2) est raccordée à la sortie (3O) du module bypass 3, constituant la sortie (OUT) du système d'amplification de signal de télécommunication (SA),
- ledit système d'amplification (SA) est configuré pour que le premier et le second mode de fonctionnement du système d'amplification soient sélectionnables avec au moins une valeur de tension de commande (Vc1, ..., Vcs)
dans lequel
- dans le premier mode de fonctionnement du système d'amplification, appelé mode amplification du système d'amplification, le module d'amplification (1) est en mode amplification du module d'amplification, le module de commutation (2) est en mode passage de signal du module de commutation (2) et le module bypass (3) est en mode isolation du module bypass, tandis que le signal de télécommunication de l'entrée (IN) du système d'amplification (SA) est amplifié par le module d'amplification (1) et que ledit signal de télécommunication amplifié est dirigé vers la sortie (OUT) du système d'amplification (SA) par le module de commutation (2) et
- dans le deuxième mode de fonctionnement du système d'amplification, appelé mode passage de signal du système d'amplification (SA), le module bypass (3) est en mode passage de signal du module bypass (3), le module d'amplification (1) est en mode coupure du module d'amplification, et le module de commutation (2) est en mode isolation du module de commutation, et le signal de télécommunication de l'entrée (IN) du système d'amplification (SA) n'est pas amplifié et est dirigé vers la sortie (OUT) du système d'amplification (SA) par le module bypass (3),
- ledit système d'amplification (SA) est configuré pour être en mode passage de signal du système d'amplification (SA) si au moins une valeur de tension de commande (Vc1, ..., Vcs) est égale à zéro volt, ce qui fait du système d'amplification un système passif qui n'a pas besoin d'alimentation électrique externe,
- le module bypass (3) comprend au moins un bloc bypass, ayant une entrée pour au moins un bloc bypass et une sortie pour au moins un bloc bypass, configuré pour avoir un premier mode de fonctionnement d'au moins un bloc bypass, et un second mode de fonctionnement d'au moins un bloc bypass, ces modes de fonctionnement d'au moins un bloc bypass sont commandés par au moins une valeur de tension de commande (Vc1, ..., Vcs),
dans lequel
- dans le premier mode de fonctionnement du bloc bypass, appelé mode passage de signal d'au moins un bloc bypass, une liaison est établie entre la sortie d'au moins un bloc bypass et l'entrée d'au moins un bloc bypass,
- dans le deuxième mode de fonctionnement du bloc bypass, appelé mode coupure d'au moins un bloc bypass, la sortie d'au moins un bloc bypass est isolée de l'entrée d'au moins un bloc bypass.
- le module d'amplification comprend au moins un bloc d'amplification dans lequel au moins un bloc d'amplification comprend un premier bloc d'amplification (BA1), dans lequel le premier bloc d'amplification (BA1) comprend au moins un transistor
dans lequel
- si le système d'amplification est en mode amplification du système d'amplification (SA), au moins un transistor est configuré pour amplifier le signal de télécommunication à l'entrée (IN) du système d'amplification de signal de télécommunication (SA) présent à l'entrée d'au moins un transistor,
- si le système d'amplification est en mode bypass du système d'amplification (SA), au moins un transistor est configuré pour être coupé, et le signal de télécommunication à l'entrée (IN) du système d'amplification de signal de télécommunication (SA) est présent à l'entrée d'au moins un transistor.

2. Système selon la demande 1, **caractérisé en ce que**
- en mode passage de signal du module bypass (3), au moins un bloc bypass ou tous les blocs bypass sont en mode passage d'au moins un bloc bypass,
et
- en mode isolation du module bypass (3), au moins un bloc bypass d'au moins un bloc bypass est en mode coupure d'au moins un bloc bypass.

3. Système selon les demandes précédentes, **caractérisé en ce que**
- au moins un bloc d'amplification a une entrée et une sortie, au moins un bloc d'amplification est configuré pour avoir un premier mode de fonctionnement et un second mode de fonctionnement dans lequel le premier mode de fonctionnement et le second mode de fonctionnement sont commandés par au moins une tension de commande (Vc1, ..., Vcs)
dans lequel
- dans le premier mode de fonctionnement du bloc d'amplification, appelé mode amplification d'au moins un bloc d'amplification, le bloc d'amplification est configuré pour amplifier le signal présent à l'entrée d'au moins un bloc d'amplification et diriger le signal amplifié vers la sortie d'au moins un bloc d'amplification,
et
- dans le deuxième mode de fonctionnement d'au moins un bloc d'amplification, appelé mode coupure d'au moins un bloc d'amplification, le bloc d'amplification est configuré pour isoler la sortie d'au moins un bloc d'amplification de l'entrée d'au moins un bloc d'amplification,
et/ou
- le module de commutation (2) comprend au moins un bloc de commutation, ayant une entrée et une sortie, dans lequel au moins un bloc de commutation est configuré pour avoir un premier mode de fonctionnement et un deuxième mode de fonctionnement, dans lequel le premier mode de fonctionnement et le deuxième mode de fonctionnement sont commandés par au moins une tension de commande (Vc1, ..., Vcs),
dans lequel
- dans le premier mode de fonctionnement d'au moins un bloc de commutation, appelé mode passage de signal d'au moins un bloc de commutation, une liaison est établie entre la sortie d'au moins un bloc de commutation et l'entrée d'au moins un bloc de commutation
- dans le deuxième mode de fonctionnement d'au moins un bloc de commutation, appelé mode coupure d'au moins un bloc de commutation, la sortie d'au moins un bloc de commutation est isolée de l'entrée d'au moins un bloc de commutation.

4. Système, selon la demande 3, **caractérisé en ce que**
- en mode amplification du module d'amplification (1), tous ou au moins un bloc d'amplification est en mode d'amplification
et
- en mode coupure du module d'amplification (1), au moins le premier bloc d'amplification (BA1) d'au moins un bloc d'amplification est en mode coupure

5. Système selon les clauses 3 et 4, **caractérisé en ce que**
- en mode passage des signaux du module de commutation (2), tous ou au moins un bloc de commutation est en mode passage,
et
- en mode isolation du module de commutation (2), au moins un bloc de commutation d'au moins un bloc de commutation est en mode coupure.
